Europäisches Patentamt

European Patent Office

Office européen des brevets

(11) Publication number: **0 111 364**
**B1**

# EUROPEAN PATENT SPECIFICATION

(45) Date of publication of patent specification: 08.03.89

(51) Int. Cl.⁴: **H 01 L 29/91,** H 01 L 21/285

(21) Application number: 83201694.3

(22) Date of filing: 01.12.83

(54) **A semiconductor device comprising at least one Schottkytype rectifier having controllable barrier height.**

(30) Priority: 08.12.82 US 447738
08.12.82 US 447745

(43) Date of publication of application:
20.06.84 Bulletin 84/25

(45) Publication of the grant of the patent:
08.03.89 Bulletin 89/10

(84) Designated Contracting States:
DE FR GB IT NL

(56) References cited:
EP-A-0 024 572
US-A-3 855 612
US-A-3 968 272
US-A-4 214 315

APPLIED PHYSICS LETTERS, vol. 37, no. 2, July
1980, pp. 205-208, NEW YORK; (US), S.
KRITZINGER et al.: "Shallow sillicide-to-silicon
contacts: The case of amorphous-Pd80Si20-to-
silicon"

(73) Proprietor: N.V. Philips' Gloeilampenfabrieken
Groenewoudseweg 1
NL-5621 BA Eindhoven (NL)

(72) Inventor: Ellwanger, Russell Craig
c/o INT. OCTROOIBUREAU B.V. Prof. Holstlaan 6
NL-5656 AA Eindhoven (NL)
Inventor: Robbins, Arthur Allen
c/o INT. OCTROOIBUREAU B.V. Prof. Holstlaan 6
NL-5656 AA Eindhoven (NL)

(74) Representative: Houbiers, Ernest Emile Marie
Gerlach et al
INTERNATIONAAL OCTROOIBUREAU B.V. Prof.
Holstlaan 6
NL-5656 AA Eindhoven (NL)

(56) References cited:
IBM TECHNICAL DISCLOSURE BULLETIN, vol.
20, no. 11a, April 1978, pp. 4384-4385, NEW
YORK (US), L. BERENBAUM et al.: "Low
temperature IN SITU sputter process for
Schottky barrier diodes"

**Description**

The invention relates to a semiconductor device comprising at least one Schottky type rectifier in which a silicon semiconductor body has an N-type region, a metal silicide layer comprising PtSi adjoins the N-type region to define a rectifying junction at an interface therebetween, and a metallic layer ohmically adjoins the silicide layer across from the junction.

Such a semiconductor device is known from U.S. Patent 3855612.

The junction between a metal and an N-type semiconductor may be either rectifying or ohmic—i.e., non-rectifying—depending on the characteristics of the materials in the metal-semiconductor system. As pointed out by R. Muller et al in *Device Electronics for Integrated Circuits* (John Wiley and Sons: New York), 1977, the work function distinguishes a rectifying junction from an ohmic junction. The work function is a measure of the average energy needed to raise an electron from the Fermi energy level to an energy level at which the electron is just free of the influence of the system. If the work function of the metal is greater than that of the semiconductor when the materials are not interacting, a rectifying junction is formed when they interact.

For the rectifying junction, a charge depletion region consisting of bound positive charges exists on the semiconductor side of the interface. In an idealized system, the electrons associated with the bound positive charges are situated in the metal right next to the interface—i.e., no more than several monolayers into the metal. This sets up an induced electric field directed across the depletion region toward the interface where the field essentially ends. As a result, a built-in voltage $\phi_I$ whose magnitude depends on the N-type dopant concentration in the semiconductor exists across the depletion region. The built-in voltage represents an energy barrier $q\phi_I$ that electrons in the semiconductor conduction band must overcome to cross the interface and enter the metal. q is the electronic charge. This energy barrier can be reduced by applying an external voltage that is positive with respect to the semiconductor. As the applied voltage is increased, a point is eventually reached at which electrons flow freely from the semiconductor to the metal. $\phi_I$ is thus indicative of the conductive forward voltage drop $\phi_{SH}$ across the rectifying junction. However, $\phi_I$ is often difficult to measure directly.

A parameter more readily ascertainable from the current/voltage characteristics of the system is the Schottky barrier height, represented as $\phi_B$ in electrostatic potential units or as $q\phi_B$ in energy units, that electrons in the metal at the Fermi level must overcome to cross the interface and enter the semiconductor. Because $\phi_B$ is greater than $\phi_I$ and is not affected to any significant degree by the applied voltage in the idealized system, very few electrons in the metal can enter the semiconductor. $\phi_B$ is also linearly related to $\phi_I$ and therefore provides a direct measure of $\phi_{SH}$.

Numerous types of metal-semiconductor rectifying elements, generally referred to as Schottky diodes, have been considered. The oldest Schottky diodes utilize aluminium as the metal and doped silicon as the N-type semiconductor. These basic Al-Si diodes are manufactured relatively easily. However, they degrade relatively fast as the aluminium intermixes with the silicon.

In view of this problem, other materials have been sandwiched between the aluminium and silicon in more recent Schottky diodes. In one of the principal arrangements, a diode is formed on a semiconductor body which has an appropriately doped N-type semiconductive region. A layer of a metal silicide adjoins the N-type region to define a rectifying junction at the interface between the N-type region and the silicide layer. The junction is still referred to as a metal-semiconductor or Schottky junction since metal silicides have been conventionally thought to be metallic in nature. The silicide is typically platinum silicide whose $q\phi_B$ with N-type silicon is 0.79—0.83 electron volt (eV) depending on the dopant concentration. As, for example, described by W. Rosvold in U.S. Patent 3 855 612, nickel is often included with platinum in the silicide layer. The nickel reduces the junction $q\phi_B$ since the nickel $q\phi_B$ is about 0.63—0.67 eV with N-type silicon.

The thickness of the silicide layer is typically on the order of 1 00 nm and is no less than about 50 nm in any known prior art Schottky diode having a conductive non-silicide layer adjoining the silicide layer across from the Schottky junction. This thickness is employed because of the conventional belief that this much silicide is needed to make the silicide layer stable and to avoid continuity defects such as pinholes in it.

A conductive non-silicide layer typically consisting of a barrier metal such as tungsten or titanium-tungsten ohmically adjoins the silicide layer across from the rectifying junction. The barrier metal substantially prevents the materials on either side of it from diffusing through it to the other side. Also, the barrier metal does not diffuse into the silicide. Finally, an aluminium layer normally overlies the barrier metal.

While known Pt-based silicide Schottky diodes perform well without significant junction degradation, they are relatively expensive because of the high cost of platinum. In a Schottky diode whose silicide layer is constituted with two or more metals, controlling the ratio of these metals to one another in the deposition target employed in forming the metallic layer later converted to silicide is also difficult. It is desirable to have a less expensive silicide Schottky-diode whose $\phi_B$ can be varied so as to appropriately tailor $\phi_{SH}$ more simply than in the prior art.

In some integrated circuits, this silicide Schottky diode is used with other Schottky diodes of different $\phi_B$. In one such semiconductor structure particularly used for an STL gate, each high-$\phi_B$ Schottky clamping diode is a PtSi diode of the above type normally formed by reacting platinum with silicon along a surface of a silicon semicon-

ducotr. Each low-$\phi_B$ Schottky output diode is a true metal-semiconductor diode typically created by depositing a metal or metal alloy such as Ti-W on the silicon semiconductor. No silicide layer lies between the silicon and Ti-W.

Only one additional masking step is typically needed to fabricate this structure compared to a structure whose Schottky diodes all have the same $\phi_B$. However, because the low-$\phi_B$ diodes are directly created by metal deposition, their rectifying junctions are not as clean as those of the reaction-created high-$\phi_B$ silicide diodes. This can lead to manufacturing difficulty and early failure.

J. Bindell et al describe another way for achieving a semiconductor structure with Schottky diodes of different $\phi_B$ in "Ion-Implanted Low-Barrier PtSi Schottky-Barrier Diodes", *IEEE Transactions on Electron Devices*, Vol. ED-27, No. 2, Feb. 1979, pp. 420—425.

In manufacturing the structure of Bindell et al, an N-type impurity is first implanted into the second region. This raises its net N-type concentration above that in the first region. An approximate 50-nm Pt layer is then deposited on an exposed surface of each region. The resultant structure is suitably heated to cause the platinum to react with silicon along the exposed surface and form the PtSi layers. Any deposited platinum that has not been converted to PtSi is appropriately removed. A layer of Ti-Pt-Au is then deposited on the resultant structure including on the PtSi layers across from the rectifying junctions and is suitably etched to form the non-silicide layers.

In manufacturing an implanted structure such as that of Bindell et al, only one additional masking step is normally required in comparison with a single-$\phi_B$ structure. However, there are different breakdown voltages between the different types of diodes. This is often undesirable because it places additional limitations on circuit design.

In short, prior art structures containing Schottky diodes of different $\phi_B$ generally are difficult to manufacture, have reliability problems, and/or unduly limit system design.

In accordance with the invention, a semiconductor device comprising at least one Schottky type rectifier in which a silicon semiconductor body has an N-type region, a metal silicide layer comprising PtSi adjoins the N-type region to define a rectifying junction at an interface therebetween, and a metallic layer ohmically adjoins the silicide layer across from the junction is characterized in that the thickness t of the silicide layer is in the range of 1,5—25 nm, thus being sufficiently thin that the actual conductor-to-semiconductor barrier height $\phi_B$ at the junction is different from the intrinsic conductor-to-semiconductor barrier height $\phi_{B0}$ at an interface between material which is the same as that of the N-type region along the junction and material which is the same as that of the silicide layer along the junction and has the same average composition as the silicide layer. The intrinsic barrier height

$\phi_{B0}$ is the barrier height that would exist if the silicide layer were effectively of infinite thickness.

More particularly, the absolute value of

$$(\phi_{B0}-\phi_B)/(\phi_{B0}-\phi_{BN})$$

is at least 15% and preferably at least 25%. $\phi_{BN}$ is the conductor-to-semiconductor barrier height at an interface between material which is the same as the N-type region along the junction and material which is the same as the metallic layer.

The invention is based on the discovery that a silicide constituted with a metal such as platinum and/or nickel appears capable of sustaining a small electric field in somewhat the manner that an electric field exists across a conventional semiconductor PN junction. By making the silicide layer thin enough, a self-induced electric field originating in the charge depletion region of the N-type region penetrates through the silicide layer and into the metallic layer. Because of this field penetration into the metallic layer, the work function of the silicide layer "mixes" with the work function of the metallic layer. As a result, $\phi_B$ differs from $\phi_{B0}$ which is the barrier height for prior art Schottky diodes.

Typically, fabrication of the present rectifier only involves depositing less metal for the silicide layer than in the prior art. Consequently, $\phi_B$ can be readily adjusted here without going through difficult-to-control deposition target composition changes used to vary the forward voltage drop in some previous Schottky diodes.

According to the invention in which the silicide layer comprises PtSi, its thickness is in the range of 1,5—25 nm. Optimally, the PtSi is 6—8 nm thick, while the metallic layer consists of tungsten or titanium-tungsten as a barrier metal. In this case, work-function mixing makes q$\phi_B$ about 0.74 eV which is about 0.07 eV less than q$\phi_{B0}$ of the comparable prior art Schottky diodes which utilize 50 nm or more of PtSi. The 0.74-eV q$\phi_B$ is quite adequate for many semiconductor applications and is achieved with a small fraction of the platinum employed in comparable prior art PtSi Schottky diodes.

In an important variation where two or more selected metals are used in the silicide layer, it is the remainder of an original metal silicide layer of greater thickness. Because of this difference, $\phi_{B0}$ is taken with respect to material which has the same average composition as the original silicide layer since its average composition generally differs from that of the (remaining) silicide layer. This occurs because the silicide layer consists of two or more generally distinct layers. One of these adjoins the N-type region, while another overlies the first and has a different average composition.

In fabricating a diode according to this variation, a metallic layer composed of the selected metals is deposited on an exposed surface of an N-type silicon semiconductive region in a semiconductor body. The resultant structure is heated to a suitable temperature to form the original silicide by reaction of the metallic layer with silicon along the surface. The metals and dopant concentration of the N-type region are so selected that the interface between the silicide layer and the remainder of the N-type region is a rectifying junction. Next, a non-insubstantial portion of the thickness of the original silicide layer is removed across from the junction so as to establish the desired $\phi_B$. Subsequently, a non-silicide layer normally consisting of a barrier metal is formed on the (remaining) silicide layer. A layer of suitable conductor such as aluminium can then be deposited on the non-silicide layer.

In accordance with a second aspect of the invention, the semiconductor device comprises a semiconductor body having a first N-type semiconductive region and a second N-type semiconductive region (which may be continuous with each other). A first metal silicide layer adjoins the first N-type region to define a first rectifying Schottky junction. A second metal silicide layer adjoins the second N-type region to define a second rectifying Schottky junction whose actual conductor-to-semiconductor barrier height $\phi_{B2}$ differs from the actual conductor-to-semiconductor barrier height $\phi_{B1}$ at the first junction. A conductive non-silicide layer ohmically adjoins the second silicide layer across from the second junction. The second silicide layer is sufficiently thin that $\phi_{B2}$ does not substantially equal the intrinsic conductor-to-semiconductor barrier height $\phi_{B20}$ at an interface between material which is the same as that of the second region along the second junction and material which is the same as that of a second silicide layer along the second junction and has the same average composition as the second silicide layer. The intrinsic barrier height $\phi_{B20}$ is the barrier height that would exist if the second silicide layer were effectively of infinite thickness.

More particularly, the absolute value of

$$(\phi_{B20}-\phi_{B2})/(\phi_{B20}-\phi_{BN2})$$

is at least 15% and preferably at least 25%. $\phi_{BN2}$ is the conductor-to-semiconductor barrier height at an interface between material which is the same as the second N-type region along the second junction and material which is the same as the non-silicide layer.

While the nature of the first rectifying junction may be conventional, it may also follow the teachings of the invention. In this case, a further conductive non-silicide layer ohmically adjoins the first silicide layer across from the first junction. The first silicide layer is sufficiently thin that $\phi_{B1}$ does not substantially equal the intrinsic barrier height $\phi_{B10}$ defined for the first junction in the same manner as $\phi_{B20}$ is defined. Likewise, the absolute value of

$$(\phi_{B10}-\phi_{B1})/(\phi_{B10}-\phi_{BN1})$$

is at least 15% where $\phi_{BN1}$ is defined for the further non-silicide layer in the same manner as $\phi_{BN2}$ is defined.

The silicide layers normally consist of the same metal silicide but at different thicknesses.

In fabricating the present structure, the metal silicide layers are first formed along the N-type regions to define the rectifying junctions. Where the regions consist of silicon, this is normally performed in two sets of similar steps. In the first set of steps, a first metallic layer composed of the metal(s) in the first silicide layer is deposited on a surface of the first N-type region exposed as the result of a masking step. The structure is then suitably heated to cause the first metallic layer to react with adjacent silicon. In the second set of steps, a second metallic layer composed of the metal(s) in the second silicide layer is likewise deposited on a surface of the second region exposed as the result of another masking step. The structure is then suitably heated to cause the second metallic layer to react with adjacent silicon.

The second set of steps is preferably performed after the first set of steps. In this case, a portion of the second metallic layer is also deposited on the metal silicide previously created along the first N-type region. This portion is converted to metal silicide during the subsequent heating step. As a result, the first silicide layer is thicker than the second silicide layer.

The non-silicide layer is subsequently formed on the second silicide layer. The further non-silicide layer is preferably formed on the first silicide layer at the same time and with the same material.

Compared to a structure whose Schottky diodes all have the same $\phi_B$, only one additional masking step is needed to fabricate the present structure. This is achieved without any significant loss in reliability. Consequently, the present structure is generally simpler and is more reliable than the above prior art structures likewise manufactured with only one additional masking step.

Brief description of the drawings

Fig. 1 is a cross-sectional side view of a semiconductor structure containing a Schottky-type rectifier according to the invention.

Figs. 2a and 2b are an energy diagram and an associated structural schematic, respectively, useful in understanding the rectifier of Fig. 1.

Figs. 3 and 4 are graphs for the variation of $\phi_B$ and

$$\left| (\phi_{B0}-\phi_B)/(\phi_{B0}-\phi_{BN}) \right|,$$

respectively, with silicide thickness in a PtSi Schottky-type diode.

Fig. 5 is a partial cross-sectional side view of a structure containing a particular embodiment of the rectifier of Fig. 1.

Figs. 6a, 6b, 6c and 6d are cross-sectional side views representing steps in a manufacturing process leading to the structure of Fig. 5.

Fig. 7 is a partial cross-sectional side view of a semiconductor structure containing Schottky-type diodes having different barrier heights in accordance with the invention.

Fig. 8 is a circuit diagram corresponding to the structure of Fig. 7.

Figs. 9a, 9b, 9c and 9d are cross-sectional side views representing steps in a process for manufacturing the structure of Fig. 7.

Like reference symbols are employed in the drawings and in the description of the preferred embodiments to represent the same or very similar item or items.

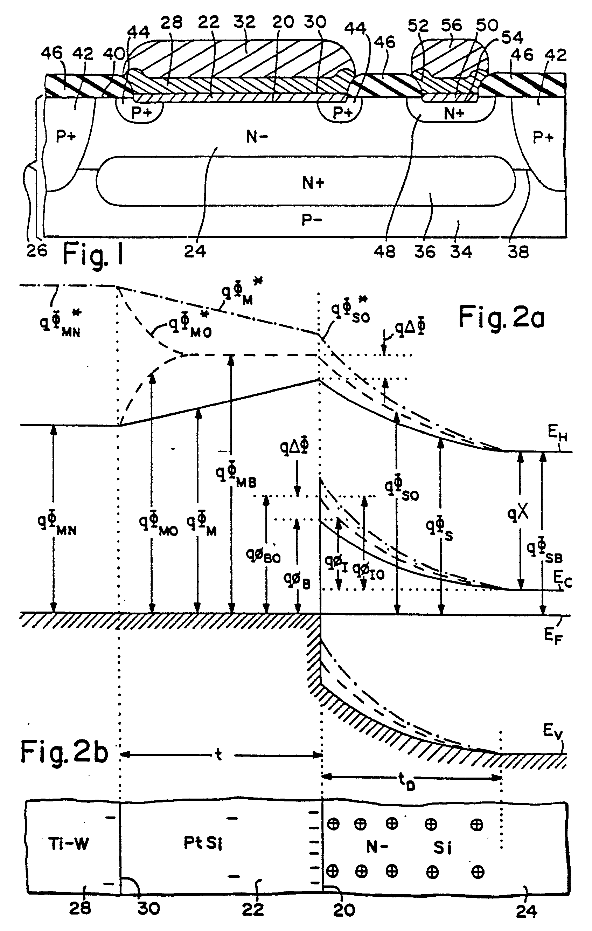

Referring to the drawings, Fig. 1 illustrates a side view of a semiconductor structure containing a Schottky-type rectifier whose actual conductor-to-semiconductor barrier height $\phi_B$ at its rectifying junction 20 is readily controllable. Junction 20 is located at the interface between a metal silicide layer 22 and an N-semiconductive region 24 in a monocrystalline silicon semiconductor body 26 of an integrated circuit.

Layer 22 consists of silicon chemically combined with platinum and may contain further metals such as nickel. In a preferred embodiment, layer 22 is PtSi for which thickness t is no more than 25 nm and is desirably no more than 10 nm. t is optimally 6—8 nm in this embodiment.

N− region 24 has a substantially uniform net N-type dopant concentration of no more than about $2 \times 10^{17}$ atoms/cm$^3$ (corresponding to a resistivity of 0.05 ohm-cm). This assures that junction 20 is indeed rectifying (rather than ohmic). The optimum net N−type dopant concentration in N− region 24 is about $9.8 \times 10^{15}$ atoms/cm$^3$ (corresponding to a resistivity of about 0.3 ohm-cm).

An electrically conductive non-silicide layer 28 consisting of a metal such as tungsten or titanium-tungsten which acts substantially as a diffusion barrier to silicon and aluminium at 520°C or less ohmically adjoins silicide layer 22 along an interface 30. Optimally, layer 28 consists of about 1 00 nm of Ti-W alloyed in the proportions of 85% tungsten to 15% titanium. The Schottky barrier height $q\phi_{BN}$ at an interface between Ti-W in the foregoing proportions and N-type monocrystalline silicon at the optimum dopant concentration above is about 0.65 eV.

In the optimal embodiment described above for which the thickness t of the PtSi in layer 22 is 6—8 nm, it is so thin that the forward voltage drop $\phi_{SH}$ across junction 20 is about 350 mV at a junction current I of 10 µA and a diode temperature T of about 25°C. $\phi_B$ is calculated as a function of $\phi_{SH}$ from the relationship

$$I = R^* A T^2 e^{-q\phi_B/kT}(e^{q\phi_{SH}/nkT} - i)$$

In this relationship, R* is Richardson's constant, k is Boltzmann's constant, and n is the ideality factor. A is the interfacial area of junction 20. In the present case, A is about $4.6 \times 10^{-6}$ cm$^2$, and n is about 1.04. Accordingly, $q\phi_B$ is about 0.74 eV. Furthermore, $q\phi_B$ can be reduced to about 0.72 eV by decreasing t to 5 nm or raised to about 0.76 eV by increasing t to 10 nm.

For purposes of comparison, the intrinsic Schottky barrier height $\phi_{B0}$ means the conductor-to-semiconductor barrier height for a reference diode whose rectifying junction is at the interface of an N-type region and a reference silicide layer of effectively infinite thickness—i.e., on the order of 1 00 nm. This N− type region is defined as being compositionally the same as N-region 24 along junction 20. Similarly, the reference silicide layer is defined as being composed of the same material as that of silicide layer 22 along junction 20. The reference silicide layer is also defined as having the same average composition as layer 22. The reference diode is thus basically the comparable prior art silicide Schottky diode.

If the reference diode is the same as the optimal diode described above except for the difference in PtSi thickness, $q\phi_{B0}$ is about 0.81 eV. This contrasts sharply with the actual 0.74-eV value for $q\phi_B$. The comparison parameter

$$| (\phi_{B0} - \phi_B)/(\phi_{B0} - \phi_{BN}) |,$$

which is a measure of the difference between the present rectifier and the reference diode, is then 44%.

Returning to Fig. 1, a layer 32 of a material suitable for electrically interconnecting metallic layer 28 with other elements of the integrated circuit lies on the top of layer 28. Layer 32 is preferably a highly conductive metal, optimally aluminium with about 1% copper having a thickness of 1,1 µm. Alternatively, layer 32 could consist of doped polycrystalline silicon or doped amorphous silicon.

In body 26, a P− substrate region 34 underlies N− region 24. A highly doped N+ buried region 36 lies along the interface 38 between regions 24 and 34. Buried region 36 extends about 6 µm below interface 38 and slightly above it as well. N− region 24, which extends about 3,7 µm upward from interface 38 to the upper surface 40 of body 26, is basically an active semiconductor region laterally isolated from other such semiconductor regions by a deep annular highly doped P+ region 42 laterally surrounding N− region 24 and extending downward about 5 00 nm below interface 38. A shallow annular highly doped P+ region 44 underlies the portion of layer 22 outside the lateral boundary of junction 20 and extends laterally outward beyond the side edge of layer 22. P+ layer 44, which extends downward about 1,2 µm below surface 40, is a guard ring for reducing leakage currents. A patterned electrically insulating layer 46 of silicon dioxide whose thickness is 3 50—4 00 nm overlies isolation region 42, parts of N− region 24, and the part of guard ring 44 extending laterally outward beyond the side edge of layer 22.

In addition, Fig. 1 illustrates an ohmic electrical contact to N− region 24. This contact consists of a highly doped N+ region 48, a metal silicide layer 50, and an electrically conductive non-silicide layer 52. N+ region 48 extends downward from surface 40 about 1,2 μm into body 26. Silicide layer 50 downwardly adjoins N+ region 48 at a junction 54. Non-silicide layer 52 ohmically adjoins silicide layer 50 at its upper surface. Also shown is an electrically conductive layer 56 lying on the top of non-silicide layer 52. Layers 50, 52 and 56 preferably consist of the same respective materials and have the same respective thicknesses as layers 22, 28 and 32. The net N-type dopant concentration in N+ region 48 along interface 54 is about $5 \times 10^{21}$ atom/cm$^3$ (corresponding to a sheet resistance of about 10 ohms/square). As a result, interface 54 is an ohmic junction. During operation, electrons travel from the contact through N− region 24 to buried region 36 and then along it to a location below silicide layer 22 where they pass back through region 24 and across junction 20.

In fabricating the structure of Fig. 1, the starting material is a boron-doped P− monocrystalline silicon semiconductor substrate having a resistivity of 7—21 ohm-cm. Arsenic is selectively diffused into the top surface of the substrate at the general location for N+ region 36. After exposing surface 38, an arsenic-doped N− epitaxial layer having a resistivity of about 0.3 ohm-cm is grown on the top of the substrate. During this and subsequent processing steps, the arsenic suitably redistributes to form buried N+ region 36 at a sheet resistance of 10—12 ohms/square.

A layer of silicon dioxide is thermally grown along the top of the structure. After opening a suitable window through this oxide layer, boron is diffused in through this window to form isolation region 42 at a sheet resistance of about 5 ohms/square. A layer of silicon dioxide is thermally grown to close this window. After opening another suitable window through the resulting oxide layer, boron is again diffused to form guard ring 44 at a sheet resistance of about 200 ohms/square. The steps of oxide growth, new window opening, and diffusion are then repeated with phosphorus to form N+ region 48. Another layer of silicon dioxide is thermally grown to close the window for N+ region 48. Layer 46 is the resultant oxide layer.

Windows are now opened through oxide layer 46 at the sites for the diode and the contact. The structure is suitably cleaned, after which an in situ sputter etch is performed with argon ions to remove any silicon dioxide in the diode and contact windows.

A layer of platinum having a thickness of about 3,5 nm is deposited according to conventional sputtering techniques on the top surface of the structure including the surface of the silicon exposed through the windows in oxide layer 46. The structure is then sintered for 20 minutes at 450°C in an environment of dry nitrogen with 1% hydrogen to cause the platinum to react with silicon along the exposed surfaces at both windows so as to form layers 20 and 50 of PtSi. In this reaction, each unit of Si thickness reacts with about one unit of Pt thickness to form about two units of PtSi thickness. Any platinum that has not reacted to form PtSi is then removed by etching with hot aqua regia. A 1 00 nm layer of Ti-W at the above proportions is deposited according to conventional sputtering techniques on the top of the structure and suitably etched with hydogen peroxide to define layers 28 and 52. In a similar manner, a layer of aluminium with about 1% copper is deposited on the top of the resultant structure and suitably patterned by etching with sulfuric/phosphoric acid to create layers 32 and 56. The structure is then finished in a conventional manner.

As described above, $\phi_B$ at junction 20 differs from $\phi_{B0}$ by a non-insubstantial amount. This difference is believed to arise because the self-induced electric field directed across the depletion region in N− region 24 toward junction 20 penetrates through the entire thickness t of silicide layer 22 and into non-silicide layer 28. The self-induced field terminates next to interface 30—i.e., no more than several monolayers into layer 28. The further field penetration through silicide layer 22 is thought to occur because the silicide in layer 22 is partially semiconductive in nature.

Figs. 2a and 2b which respectively show an energy diagram and an associated schematic side view of a slice through N− region 24, silicide layer 22, and non-silicide layer 28 facilitate the qualitative understanding of the device physics leading to this phenomenon. To simplify the explanation, Figs. 2a and 2b represent the case in which no external voltage is applied across the diode. The solid lines in Fig. 2a denote actual energy variations in the present diode for the case, as above, where $\phi_{BN}$ for the material of non-silicide layer 28 is less than $\phi_{B0}$ and where the composition of silicide layer 22 is uniform across its thickness (as with PtSi). The dashed lines in Fig. 2a denote the corresponding energy variations for the reference diode whose silicide layer thickness is effectively infinite.

The circled "+" signs in the N− region 24 of Fig. 2b represent the bound positive charges of the depletion region whose width (thickness) is denoted as $t_D$. The "−" signs in layers 22 and 28 represent the electrons associated with the bound positive charges for achieving overall charge neutrality. These "−" signs are divided into one part along junction 20 for inducing the basic electric field across the depletion region and another part located in layers 22 and 28 away from junction 20 for inducing the field portion that penetrates through silicide layer 22.

The work function is generally denoted as in electrostatic potential units or as q in energy units. $\Phi_{SB}$ and $\Phi_{MB}$ are the bulk values of the N-type semiconductor and the metal silicide, respectively, when they are not interacting (i.e., there is no silicide-semiconductor rectifying junc-

tion). $\Phi_{SB}$ exists in the N-type semiconductor outside its charge depletion region. In order for rectification to occur, $\Phi_{MB}$ exceeds $\Phi_{SB}$. Also, the work function $\Phi_{MN}$ of non-silicide layer 28 (or the corresponding non-silicide layer in the reference diode) is less than $\Phi_{MB}$ (since $\phi_{BN}$ is less than $\phi_{B0}$ here).

With these considerations in mind, a good starting place is the Fermi energy $E_F$ which is constant in a Schottky-type diode in the absence of an applied voltage. The sum of $E_F$ and the work function at any point in the diode is the energy $E_H$ at which an electron is just free of the influence of the diode. Although $E_H$ varies, it is continuous across any conductor-semiconductor interface or any conductor-conductor interface.

Looking first at the reference diode, the intrinsic work function $\Phi_{S0}$ of its N-type region thereby increases from $\Phi_{SB}$ outside the depletion region to a maximum at its rectifying junction as progressively more energy is needed to raise an electron to $E_H$. Since $E_F$ is constant and $E_H$ is continuous, $\Phi_{S0}$ meets the intrinsic work function $\Phi_{M0}$ of the silicide layer of the reference diode at its rectifying junction. At that point, $\Phi_{M0}$ equals $\Phi_{MB}$.

Near the interface between the silicide and non-silicide layers in the reference diode, $\Phi_{M0}$ drops down to $\Phi_{MN}$.

In the diode of Fig. 1, the actual work function $\Phi_S$ for N− region 24 similarly rises from $\Phi_{SB}$ outside the depletion region to a maximum at junction 20 where $\Phi_S$ meets the actual work function $\Phi_M$ for silicide layer 22. Likewise, $\Phi_M$ meets $\Phi_{MN}$ at junction 30. The important difference between the reference diode and the rectifier of Fig. 1 is that $\Phi_M$ is always less than $\Phi_{MB}$ because of the electric-field penetration into non-silicide layer 28. This generally lowers $\Phi_M$ as $\Phi_{M0}$ mixes with lower-valued $\Phi_{MN}$. Accordingly, the value of $\Phi_M$ at junction 20 is lower than $\Phi_{M0}$ at the rectifying junction of the reference diode by an amount $\Delta\Phi$.

The difference $\Delta\Phi$ is reflected down as the difference between $\phi_{B0}$ and $\phi_B$. This occurs because the difference $qX$ between $E_H$ and the lowest energy $E_C$ in the semiconductor conduction band is constant from point to point. As $E_H$ rises across the depletion region, $E_C$ rises in the same manner. The change in $E_C$ is the actual built-in semiconductor-to-conductor energy barrier $q\phi_I$ which is thereby $q\Delta\Phi$ less than the intrinsic built-in semiconductor-to-conductor energy barrier $q\phi_{I0}$. Similarly, $q\phi_B$ is the difference between $E_F$ and $E_C$ at junction 20. Consequently, $\phi_{B0}$ exceeds $\phi_B$ by $\Delta\Phi$.

Alternatively, $\Phi_{MN}$ for non-silicide layer 28 might exceed $\Phi_{M0}$. $\phi_B$ would then exceed $\phi_{B0}$. The dot-and-dash lines in Fig. 2a represent the actual energy variations for this complementary case, each of the relevant parameters being denoted with an "*". That is, the parameters $\Phi_{MN*}$, $\Phi_{M*}$, $\Phi_{M0*}$, and $\Phi_S$ for the complementary case correspond respectively to $\Phi_{MN}$, $\Phi_M$, $\Phi_{M0}$, and $\Phi_S$. In the complementary case, the basic device physics is largely the same as in the main case except that the various differences are reversed in sign. Accordingly, no further explanation is necessary here.

For a pair of conductors, the difference between their work functions is representative of the difference between their barrier heights with the same semiconductor. In particular, the difference between $\Phi_{M0}$ and $\Phi_{MN}$ is representative of the difference between $\phi_{B0}$ and $\phi_{BN}$. The parameter

$$|\ (\phi_{B0}-\phi_B)/(\phi_{B0}-\phi_{BN})\ |,$$

hereafter usually referred to as $\varepsilon$, is therefore indicative of the amount of work function mixing in the present diode.

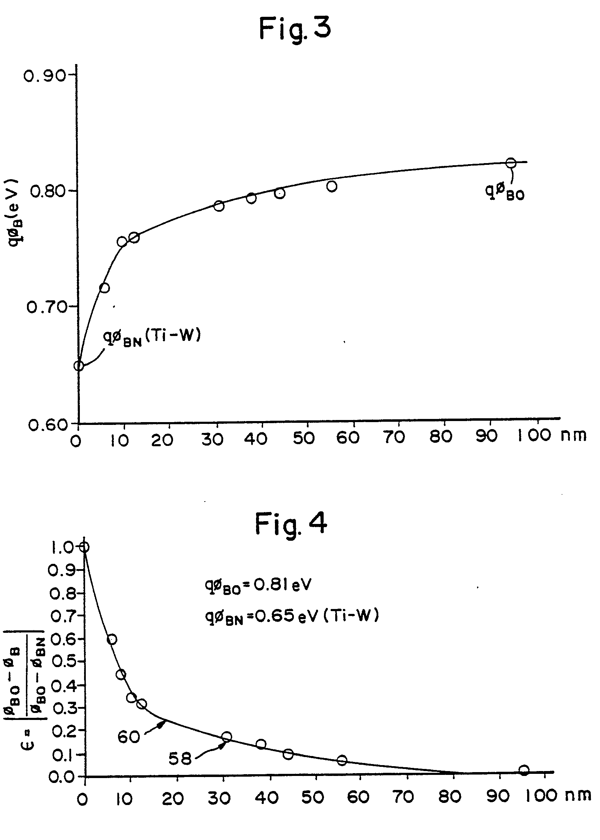

Fig. 3 is a graph showing the experimental variation of $\phi_B$ with silicide thickness t for the PtSi diode. The end points on this curve are $\phi_{B0}$ when t is effectively infinite—i.e., about 1 00 nm—and $\phi_{BN}$ when t is zero—i.e., N− region 24 directly adjoins non-silicide layer 28. Fig. 4 is a graph showing the corresponding curve for the variation of $\varepsilon$ with t.

Some statistical variation does exist in the data shown. In addition, there is some difficulty in ascertaining t because of limitations in the measurement apparatus/technique. Allowing for statistical variation and measurement accuracy, it is nonetheless clear that $\phi_B$ is significantly different from $\phi_{B0}$ when t is about 30 nm or less. This corresponds to the range beginning at point 58 in Fig. 4 where $\varepsilon$ is at least 15%. More particularly, the curve starts to bend sharply near the point 60 at which $\varepsilon$ is about 25%. The range for greater than 25% is even more preferred since $\phi_B$ can vary greatly within this range for small changes in t.

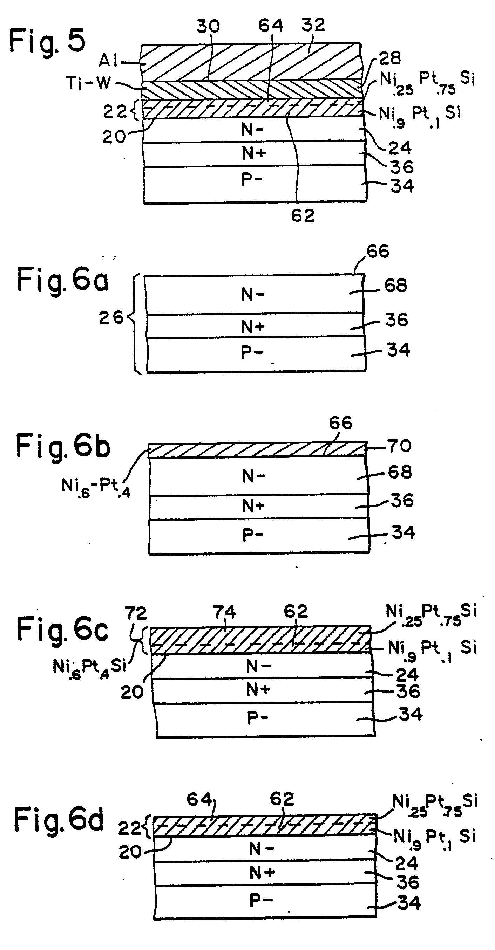

Turning to Fig. 5, it illustrates an embodiment of the diode of Fig. 1 in which layer 22 is a silicide of nickel and platinum divided generally into a pair of layers 62 and 64. Lower layer 62 adjoins N− region 24 along interface 20 and consists of $Ni_YPt_{1-Y}Si$ where Y is variable between 0 and 1. Upper layer 64 adjoins non-silicide layer 28 along interface 30 and consists of $Ni_ZPt_{1-Z}Si$ where Z is variable between 0 and Y. Accordingly, lower layer 62 is Ni-rich compared to upper layer 64. In the embodiment shown, Y is about 0.9, and Z is about 0.25. Non-silicide layer 28 again consists of Ti-W in the above proportions.

As stated above, the intrinsic barrier height $\phi_{B0}$ for the reference diode is defined with respect to a silicide layer having the same average composition as layer 22. This is important here because it takes into account the compositional difference between layers 62 and 64.

Layer 22 in the rectifier of Fig. 5 is preferably the remainder of an original silicide layer of greater thickness. In this case, $\phi_{B0}$ is defined with respect to a reference silicide layer which is the same as the original silicide layer along junction 20 and has the same average composition as the original silicide layer.

The ability to control $\phi_B$ by making upper layer 64 sufficiently thin is believed to occur because of electric-field penetration through silicide layer 22 into non-silicide layer 28. Although there are slight differences in the work-function mixing because layer 22 is divided into layers 62 and 64 of different average composition, the device physics is basically the same as described for Figs. 2a and 2b.

Figs. 6a, 6b, 6c and 6d illustrate steps in a method for fabricating the particular rectifier shown in Fig. 5. In this method, silicon semiconductor body 26 is initially processed in the manner described above for the rectifier of Fig. 1 up through the creation of the windows for the diode and the electrical contact (not shown here) down to the exposed silicon surfaces 66 of the N− portion 68 remaining from the original epitaxial layer. At this point, the structure appears as shown in Fig. 6a in which N− region 68 downwardly adjoins buried region 36. Body 26 preferably also includes doped regions 42, 44 and 48 at this point as shown in Fig. 1 but not illustrated here. In the following steps, layers 50, 52 and 56 for the contact are preferably formed at the same time, with the same materials, and to the same thicknesses as layers 22, 28 and 32, respectively. To simplify the discussion, no further reference is made to the contact.

A metallic layer 70 of Ni-Pt in the proportions of 60% nickel to 40% platinum is now deposited according to conventional sputtering techniques to a thickness of about 50 nm on surface 66 as depicted in Fig. 6b. The structure is sintered for 20 minutes at 500°C in an environment of dry nitrogen with 1% hydrogen to cause the nickel and platinum to react with silicon along surface 66 and form an original silicide layer 72 which adjoins the remainder 24 of N− region 68 along interface 20 as shown in Fig. 6c. The resulting thickness of silicide layer 72 is about 1 00 nm, while its average composition is $Ni_{.6}Pt_{.4}Si$. During this sintering step, silicide layer 72 actually forms as lower silicide layer 62 and an original upper silicide layer 74. The average composition of lower layer 62 is about $Ni_{.9}Pt_{.1}Si$. The average composition of upper layer 74 is about $Ni_{.25}Pt_{.75}Si$. Any Ni-Pt that has not reacted to form silicide is then removed by etching with room-temperature aqua regia.

A portion of the thickness of upper layer 74 is removed by milling with argon ions so as to leave silicide layer 22 of which upper portion 64 is the remainder of original upper layer 74 as shown in Fig. 6d. A 1 00 nm layer of Ti-W at the above proportions is deposited according to conventional sputtering techniques on the top of the structure and suitably etched with hydrogen peroxide to define non-silicide layer 28 as shown in Fig. 5. In a similar manner, a layer of aluminium with about 1% copper is deposited on the top of the structure and suitably patterned by etching with sulfuric/phosphoric acid to create layer 32. As indicated above, lower layer 62 is so thin that removal of the portion of original upper layer 74 enables $\phi_B$ to be reduced from about 0.74 eV when upper layer 74 is intact to about 0.66 eV when upper layer 74 is entirely gone.

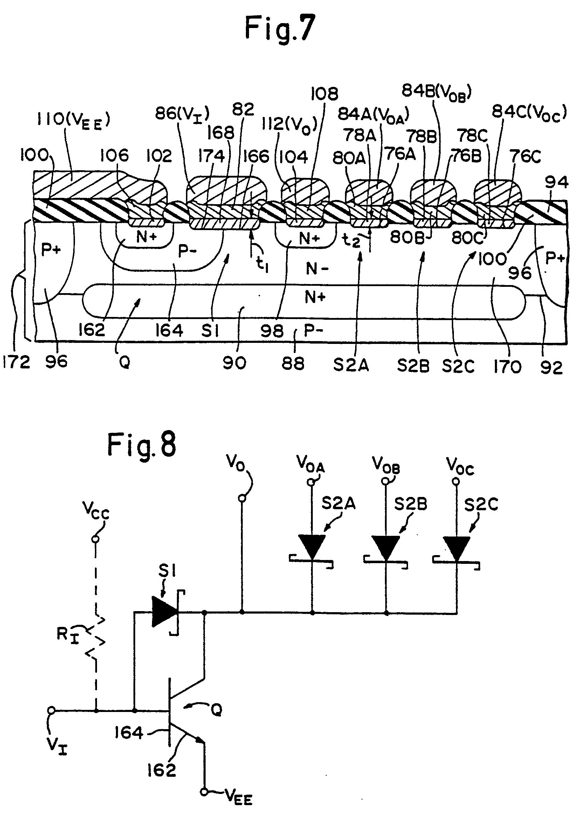

The rectifier of Fig. 1 is particularly suitable for semiconductor structures containing Schottky-type diodes of different $\phi_B$. Fig. 7 illustrates a side view of such a structure employable in an STL portion of an integrated circuit. Fig. 8 is the corresponding circuit diagram.

The structure centers around an NPN bipolar transistor Q whose N+ emitter 162 receives a supply voltage $V_{EE}$ preferably at ground reference (0 volt) and whose P− base 164 receives a digital input signal $V_I$. Base 164 is also coupled through an input resistor $R_I$ (not shown in Fig. 7) to another supply voltage $V_{CC}$ which is preferably 2,5 volts. The collector of transistor Q is connected to the cathode of a Schottky-type diode S1 whose anode is connected to base 164. In addition to providing a direct digital output signal $V_O$, the collector is also connected to the cathodes of three substantially identical Schottky-type diodes S2A, S2B and S2C whose anodes provide further output digital signals $V_{OA}$, $V_{OB}$ and $V_{OC}$, respectively. The actual conductor-to-semiconductor barrier height $\phi_{B1}$ for diode S1 exceeds the actual conductor-to-semiconductor barrier height $\phi_{B2}$ for any of diodes S2A, S2B and S2C. Consequently, the conductive forward voltage drop $\phi_{SH1}$ for diode S1 exceeds the conductive forward voltage drop $\phi_{SH2}$ for diode S2A, S2B, or S2C.

The rectifying junction 166 for diode S1 is at the interface between a metal silicide layer 168 and an underlying N− semiconductive region 170 in a monocrystalline silicon semiconductor body 172. Silicide layer 168 also extends laterally away from N− region 170 in such a manner as to downwardly adjoin P− region 164 at an ohmic junction 174. The rectifying junctions 76A, 76B and 76C for diodes S2A, S2B and S2C, respectively, lie at the interfaces between N− region 170 and metal silicide layers 78A, 78B and 78C, respectively.

Region 170 has a substantially uniform net N-type dopant concentration of no more than about $2 \times 10^{17}$ atoms/cm³ (corresponding to a resistivity of 0.05 ohm-cm). This assures that junctions 166, 76A, 76B and 76C are actually rectifying junctions. The optimum net N-type dopant concentration in region 170 is about $9.8 \times 10^{15}$ atom/cm³ (corresponding to a resistivity of about 0.3 ohm-cm).

While any of the metal silicides described above might be used in layers 168, 78A, 78B and 78C, the preferred silicide is PtSi. The thickness $t_1$ of layer 166 is 1 00—1 10 nm (or more). Accordingly, $q\phi_{B1}$ is about 0.81 eV. This is the corresponding intrinsic Schottky barrier height $q\phi_{B10}$. $\phi_{SH1}$ is then 430 mV at a junction current of 10 μa. As in Fig. 1, the thickness $t_2$ of each silicide layer 78A, 78B or 78C is at least 1,5 nm and is preferably at least 5 nm. $t_2$ is no more than 10 nm and is optimally 5—6 nm. As a result, $\phi_{B2}$ depends on the material across from junctions 76A, 76B and 76C because of penetration of the self-induced electric fields entirely through layers 78A, 78B and 78C.

Electrically conductive non-silicide layers 80A, 80B and 80C consisting of about 1 00 nm of Ti-W alloyed in proportions of 85% tungsten to 15% titanium adjoin silicide layers 78A, 78B and 78C, respectively, along their upper surfaces. The Schottky barrier height $q\phi_{BN2}$ at an interface between Ti-W in the foregoing proportions and N-type monocrystalline silicon at the optimum dopant concentration above is about 0,65 eV. As a consequence, $q\phi_{B2}$ is about 0.72 eV at the optimum value of $t_2$, while $\phi_{SH2}$ is 340 mV at a junction current of 10 µA. $q\phi_{B2}$ is thus significantly different from the intrinsic Schottky barrier height $q\phi_{B20}$ of 0.81 eV. The comparison parameter

$$\left| (\phi_{B20}-\phi_{B2})/(\phi_{B20}-\phi_{BN2}) \right|$$

is about 56% in this case. More generally,

$$\left| (\phi_{B20}-\phi_{B2})/(\phi_{B20}-\phi_{BN2}) \right|$$

is at least 15% and more preferably at least 25% as discussed for Fig. 4.

In the present case, $\phi_{B10}$ equals $\phi_{B20}$ since the net N-type dopant concentration along junctions 166, 76A, 76B and 76C in N- region 170 is the same and since silicide layers 168, 78A, 78B and 78C consist of PtSi—i.e., they have the same average composition as well as the same composition along junctions 166, 76A, 76B and 76C. If this were not the case, $\phi_{B10}$ would generally not equal $\phi_{B20}$.

Another 1 00 nm non-silicide layer 82 consisting of Ti-W alloyed in the foregoing proportions adjoins silicide layer 168 along its upper surface. The Schottky barrier height $\phi_{BN1}$ at an interface between Ti-W so alloyed and N-type monocrystalline silicon at the same dopant concentration as region 170 along interface 166 then equals $\phi_{BN2}$.

If the dopant concentration in region 170 along interface 166 differed from that in region 170 along interfaces 78A, 78B and 78C, $\phi_{BN1}$ would not generally equal $\phi_{BN2}$. This is also true if non-silicide layer 82 consists of a different material than that of non-silicide layers 80A, 80B and 80C.

Layers 84A, 84B and 84C consisting of a material suitable for electrically interconnecting non-silicide layers 80A, 80B and 80C, respectively, with other elements of the integrated circuit lie on the tops of layers 80A, 80B and 80C. Likewise, a layer 86 of the same material lies on the top of non-silicide layer 82. Layers 84A, 86B, 84C and 86 are preferably a highly conductive metal, optimally aluminium with about 1% copper having a thickness of about 1,1 µm. Alternatively, they could consist of doped polycrystalline silicon or doped amorphous silicon.

A P- substrate region 88 in body 172 underlies N- region 170. A highly doped N+ buried region 90 lies along the interface 92 between regions 170 and 88. Buried region 90, which extends about 6 µm below interface 92 and slightly above it as well, provides a conductive path for electrons travelling between parts of the structure. N- region 170, which extends about 3,7 µm upwards

from interface 92 to the upper surface 94 of body 172, is basically an active semiconductive region laterally isolated from other such semiconductor regions by a deep annular highly doped P+ region 96 laterally surrounding region 170 and extending downwards about 5 00 nm below interface 92. N- region 170 laterally and upwardly surrounds P- region 164 which extends downward about 1,2 µm below surface 94. Similarly, P- region 164 laterally and upwardly encloses N+ region 162 along surface 94. The final semiconductive region in body 172 is a highly doped N+ region 98 laterally and upwardly enclosed by N- region 170. In combination, N-type regions 170, 90 and 98 form the collector for transistor Q. N+ regions 162 and 98 both extend about 1,0 µm downward from surface 94.

A patterned electrically insulating layer 100 of silicon dioxide whose thickness is 3 50—4 00 nm overlies body 172 along surface 94 except at the locations of silicide layers 168, 78A, 78B and 78C and at the locations of silicide layers 102 and 104 which ohmically adjoin N+ regions 162 and 98, respectively. Layers 102 and 104 preferably consist of PtSi having the same thickness as layers 78A, 78B and 78C. Layers 106 and 108 consisting of 1 00 nm of Ti-W in the above proportions lie on the top surfaces of silicide layers 102 and 104, respectively. Finally, layers 110 and 112 having the same thickness as layers 84A, 84B, 84C and 86 and consisting of the same highly conductive material lie on the tops of non-silicide layers 106 and 108, respectively.

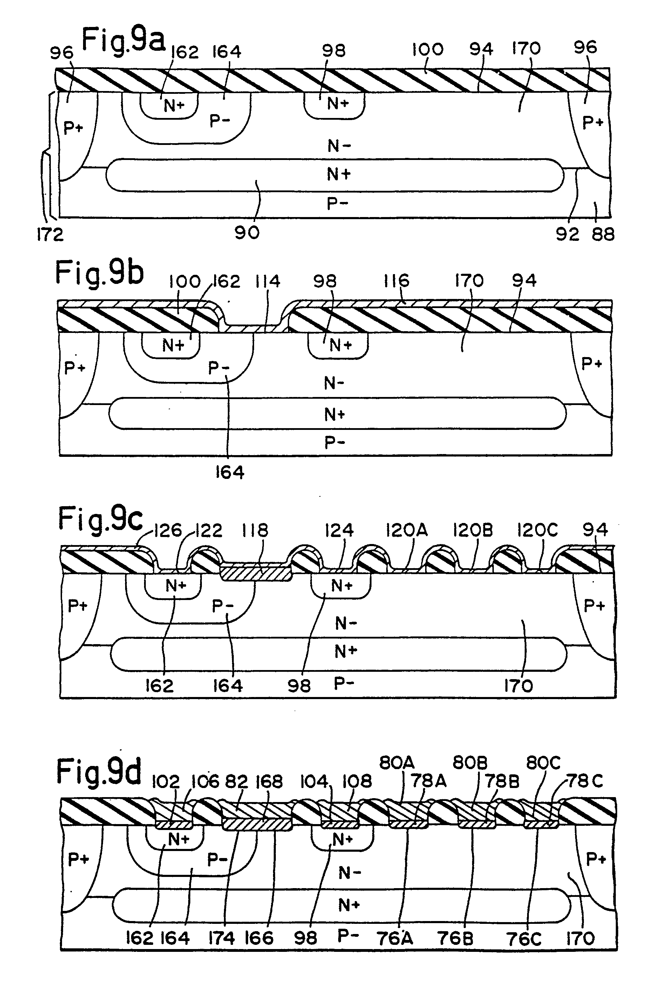

Figs. 9a, 9b, 9c and 9d illustrate steps in a method for fabricating the structure of Fig. 8. Conventional masking, etching and cleaning techniques which are largely not further referred to in order to simplify the discussion are employed in creating the various doped regions and overlying layers. In many of the diffusion steps, the respective impurities could alternatively be introduced by ion implantation.

The starting material is a boron-doped P-monocrystalline silicon semiconductor substrate having a resistivity of about 7—21 ohm-cm. Arsenic is selectively diffused into the top surface of the substrate at the general location for N+ region 90. After exposing surface 92, an arsenic doped N- epitaxial layer having a resistivity of about 0.3 ohm-cm is grown on the top of the substrate. During this and subsequent processing steps, the arsenic suitably redistributes to form buried region 90 at a sheet resistance of 10—12 ohms/square.

A layer of silicon dioxide is thermally grown along the top of the structure. After opening a suitable window through this oxide layer, boron is diffused in through this window to form isolation region 96 at a sheet resistance of 5 ohms/square. A layer of silicon dioxide is thermally grown to close this window. After opening another window at the general location for P- region 164, boron is again diffused in to form a P- region having a sheet resistance of 200 ohms/square. Another layer of silicon dioxide is thermally grown to close this last window. After opening suitable windows through the now resulting oxide layer, phosphorus is diffused in to form N+ regions 162 and 98 at a sheet resistance of 10 ohms/square. Yet another layer of silicon dioxide is thermally grown to close the windows for regions 162 and 98. Layer 100 is the resultant oxide layer. At this point, the structure appears as in Fig. 9a. N− region 170 is the remainder of the original epitaxial layer that has not been further operated on, while base 164 is the remainder of the original diffused P− region excluding emitter 162.

In a first set of diode fabrication steps, a photoresist mask is employed in opening a window through oxide layer 100 at the site for diode S1. This window also overlies part of P− region 164. The structure is wet precleaned, after which an in situ sputter etch is performed with argon ions to move any silicon dioxide in the window for diode S1. This exposes silicon surface portion 114 of surface 94.

A metallic layer 116 of platinum having a thickness of about 50 nm is now deposited according to conventional sputtering techniques on the top of the structure including on surface 114 as depicted in Fig. 9b. The structure is sintered for 20 minutes at 450°C in a wet nitrogen environment to cause the platinum to react with silicon along surface 114 and form a PtSi layer 118 having a thickness of about 1 00 nm. In converting platinum to PtSi in steps such as this one, each unit of Si thickness reacts with about one unit Pt thickness to form about two units of PtSi thickness. Any platinum that has not reacted to form PtSi is removed by etching with hot aqua regia.

In a second set of diode fabrication steps, another photoresist mask is utilized in opening windows through oxide layer 100 at the sites for diodes S2A, S2B, and S2C and also above N+ regions 162 and 98. The structure is again wet precleaned, after which another in situ sputter etch is performed with argon ions to remove any silicon dioxide in the windows for diodes S2A, S2B and S2C and N+ regions 162 and 98. This respectively exposes surface portions 120A, 120B, 120C, 122 and 124 of surface 94.

A metallic layer 126 of platinum having a thickness of 2,5—3 nm is deposited according to conventional sputtering techniques on the top of the structure including on surfaces 120A, 120B, 120C, 122 and 124 as shown in Fig. 9c. In this deposition, a portion of metallic layer 126 is also deposited on the top of PtSi layer 118. The structure is sintered for ten minutes at 450°C in a dry nitrogen environment to cause the platinum to react with silicon along surfaces 120A, 120B, 120C, 122 and 124 so as to form silicide layers 78A, 78B, 78C, 102 and 104. During this heating step, the portion of metallic layer 126 on PtSi layer 118 likewise reacts with adjacent silicon to convert layer 118 into silicide layer 168 which is 5—6 nm thicker. Any platinum that has not reacted to form PtSi is again removed by etching with hot aqua regia.

A 1 00 nm layer of Ti-W at the above proportions is deposited according to conventional sputtering techniques on the top of the structure and suitably etched with hydrogen peroxide to define layers 80A, 80B, 80C, 82, 106 and 108 as illustrated in Fig. 9d. In a similar manner, a layer of aluminium with about 1% copper is deposited on the top of the structure and suitably patterned by etching with nitric/phosphoric/acetic acid to create layers 84A, 84B, 84C, 110 and 112 as shown in Fig. 7. The structure is then finished in a conventional manner.

In the structure of Fig. 7, fabricated as shown in Figs. 9a—9d, $\phi_{B1}$ was chosen to equal $\phi_{B10}$. In other structures which utilize the diode of Fig. 1, the silicide layer corresponding to layer 168 for diode S1 might be sufficiently thin that $\phi_{B1}$ does not substantially equal $\phi_{B10}$. In this case,

$$\left| (\phi_{B10} - \phi_{B1})/(\phi_{B10} - \phi_{BN1}) \right|$$

is again preferably not less than 15% and even more preferably not less than 25%.

While the invention has been described with reference to particular embodiments, this description is solely for the purpose of illustration and is not to be constructed as limiting the scope of the invention claimed below. For example, in presence of two or more Schottky rectifiers the compositions of their metallic layers might differ even though their silicide layers consist of the same material. The compositions of the silicide layers might differ as long as at least one of them is sufficiently thin so that $\phi_B$ is not substantially the same as $\phi_{B0}$ for that one.

## Claims

1. A semiconductor device comprising at least one Schottky type rectifier in which a silicon semiconductor body has an N-type region, a metal silicide layer comprising PtSi adjoins the N-type region to define a rectifying junction at an interface therebetween, and a metallic layer ohmically adjoins the silicide layer across from the junction, characterized in that the thickness t of the silicide layer is in the range of 1.5—25 nm, thus being sufficiently thin that the actual conductor-to-semiconductor barrier height $\phi_B$ at the junction is different from the intrinsic conductor-to-semiconductor barrier height $\phi_{B0}$ at an interface between said N-type region and said silicide layer.

2. A semiconductor device as in Claim 1 characterized in that t is at least 5 nm.

3. A semiconductor device as in Claim 1 characterized in that the absolute value of

$$(\phi_{B0} - \phi_B)/(\phi_{B0} - \phi_{BN})$$

is not less than 0.15 where $\phi_{BN}$ is the metal-to-semiconductor barrier height at an interface between material which is the same as that of the N-type region along the junction and material which is the same as that of the metallic layer.

4. A semiconductor device as in Claim 2 characterized in that the absolute value of

$$(\phi_{B0}-\phi_B)/(\phi_{B0}-\phi_{BN})$$

is not less than 0.25.

5. A semiconductor device as in Claim 2 characterized in that the metallic layer acts as a diffusion barrier to silicon and aluminium at a temperature not greater than 520°C.

6. A semiconductor device as in Claim 3 characterized in that the silicide layer comprises a first layer adjoining the N-type region and a second layer overlying the first layer across from the junction and having a different average composition than the first layer.

7. A semiconductor device as in Claim 6 characterized in that the average composition of the first layer is substantially $Ni_YPt_{1-Y}Si$ where Y is variable between 0 and 1 and that the average composition of the second layer is substantially $Ni_ZPt_{1-Z}Si$ where Z is variable between 0 and Y.

8. A semiconductor device as in any of claims 1—7 characterized in that said metal silicide layer is constituted with at least two selected metals and in that said silicide layer is the remainder of an original metal silicide layer of greater thickness.

9. A semiconductor device as in any of Claims 1—8 comprising a rectifier with an actual conductor-to-semiconductor barrier height $\phi_{B1}$ and an intrinsic barrier height $\phi_{B10}$ characterized in that the device comprises in addition a further rectifier with a further N-type semiconductor region and a further metal silicide layer adjoining said further region to define a further rectifying junction having an intrinsic conductor-semiconductor barrier height $\phi_{B20}$ and an actual conductor-to-semiconductor barrier height $\phi_{B2}$ different from $\phi_{B1}$.

10. A semiconductor device as in Claim 9 characterized in that the N-type regions are continuous with each other and have substantially the same net N-type dopant concentration along the junctions, and in that the silicide layers have substantially the same composition along the junctions and substantially the same average composition, whereby $\phi_{B10}$ equals $\phi_{B20}$.

11. A semiconductor device as in Claim 10 characterized in that both rectifiers have metallic layers comprising the same material, whereby $\phi_{BN1}$ equals $\phi_{BN2}$.

12. A semiconductor device as in any of Claims 9—11 characterized in that the silicide layers comprise the same metal silicide at different thicknesses.

## Patentansprüche

1. Halbleiteranordnung mit wenigstens einem Schottky-Gleichrichter, wobei ein Halbleiterkörper ein N-leitendes Gebiet aufweist, wobei eine Silicidschicht mit PtSi an das N-leitende Gebiet grenzt zum Bestimmen eines Gleichrichterüberganges an einer zwischen denselben liegenden Schnittstelle und wobei eine Metallschicht von jenseits des Uebergangs ohmisch an die Silicidschicht grenzt, dadurch gekennzeichnet, dass die Dicke t der Silicidschicht im Bereich von 1,5—25 nm liegt, was dünn genug ist, damit die reelle Leiter-zu-Halbleiterbarrierenhöhe $\phi_B$ an dem Übergang anders ist als die intrinsike Leiter-zu-Halbleiterbarrierenhöhe $\phi_{B0}$ an einer Schnittstelle zwischen dem N-leitenden Gebiet und der Silicidschicht abweicht.

2. Halbleiteranordnung nach Anspruch 1, dadurch gekennzeichnet, dass t wenigstens 5 nm ist.

3. Halbleiteranordnung nach Anspruch 1, dadurch gekennzeichnet, dass der Absolutwert von

$$(\phi_{B0}-\phi_B)/(\phi_{B0}-\phi_{BN})$$

nicht kleiner als 0,15 ist, wobei $\phi_{BN}$ die Metall-zu-Halbleiterbarrierenhöhe an einer Schnittstelle zwischen Material, das dasselbe ist wie das des N-leitenden Gebietes längs des Übergangs und Material, das dasselbe ist wie das der Metallschicht.

4. Halbleiteranordnung nach Anspruch 2, dadurch gekennzeichnet, dass der Absolutwert von

$$(\phi_{B0}-\phi_B)/(\phi_{B0}-\phi_{BN})$$

nicht kleiner ist als 0,25.

5. Halbleiteranordnung nach Anspruch 2, dadurch gekennzeichnet, dass die Metallschicht bei einer Temperatur unter 520°C als eine Diffusionsbarriere zu Silizium und Aluminium wirksam ist.

6. Halbleiteranordnung nach Anspruch 3, dadurch gekennzeichnet, dass die Silicidschicht eine erste Schicht aufweist, die an das N-leitende Gebiet grenzt und eine zweite Schicht, die über die erste Schicht liegt und zwar von dem Übergang her und eine andere mittlere Zusammensetzung hat als die erste Schicht.

7. Halbleiteranordung nach Anspruch 6, dadurch gekennzeichnet, dass die mittlere Zusammensetzung der ersten Schicht im wesentlichen $Ni_YPt_{1-Y}Si$ ist, wobei Y eine Veränderliche zwischen 0 und 1 ist und dass die mittlere Zusammensetzung der zweiten Schicht im wesentlichen $Ni_ZPt_{1-Z}Si$ ist, wobei Z eine Veränderliche zwischen 0 und Y ist.

8. Halbleiteranordnung nach einem der Ansprüche 1 bis 7, dadurch gekennzeichnet, dass die Metallsilicidschicht mit wenigstens zwei selektierten Metallen gebildet ist und dass die Silicidschicht der Rest einer ursprünglichen Metallsilicidschicht mit einer grösseren Dicke ist.

9. Halbleiteranordnung nach einem der Ansprüche 1 bis 8 mit einem Gleichrichter mit einer reellen Leiter-zu-Halbleiterbarrierenhöhe $\phi_{B1}$ und einer intrinsiken Barrierenhöhe $\phi_{B10}$, dadurch gekennzeichnet, dass die Anordnung ausserdem einen weiteren Gleichrichter aufweist mit einem weiteren N-leitenden Halbleitergebiet und einer weiteren Metallsilicidschicht, die an das weitere Gebiet grenzt und einen weiteren Gleichrichterübergang definiert mit einer intrinsiken Leiter-zu-Halbleiterbarrierenhöhe $\phi_{B20}$ und einer reellen Leiter-zu-Halbleiterbarrierenhöhe $\phi_{B2}$, die von $\phi_{B1}$ abweicht.

10. Halbleiteranordnung nach Anspruch 9, dadurch gekennzeichnet, dass die N-leitenden Gebiete ineinander übergehen und im wesentlichen dieselbe Netto-N-leitende Dotierungskonzentration längs der Übergänge haben und dass die Silicidschichten im wesentlichen dieselbe Zusammensetzung längs der Übergänge haben und im wesentlichen dieselbe mittlere Zusammensetzung haben, wobei $\phi_{B10}$ gleich $\phi_{B20}$ ist.

11. Halbleiteranordnung nach Anspruch 10, dadurch gekennzeichnet, dass die beiden Gleichrichter Metallschichten mit demselben Material haben, wobei $\phi_{BN1}$ gleich $\phi_{BN2}$ ist.

12. Halbleiteranordnung nach einem der Ansprüche 9 bis 11, dadurch gekennzeichnet, dass die Silicidschichten dasselbe Metallsilicid mit verschiedenen Dicken haben.

**Revendications**

1. Dispositif semiconducteur comportant au moins un redresseur de type Schottky dans lequel, un corps semiconducteur de silicium présente une région de type N, une couche de siliciure de métal comportant du PtSi est contiguë à la région de type N de façon à définir une jonction redresseuse à une interface qui la sépare de cette région, et une couche métallique est ohmiquement contiguë à la couche de siliciure caractérisé en ce que l'épaisseur t de la couche de siliciure est comprise entre 1,5 et 25 nm, de sorte que cette couche de siliciure est suffisamment mince pour que la hauteur effective $\phi_B$ de la barrière conducteur-semiconducteur à la jonction diffère de la hauteur intrinsèque $\phi_{B0}$ de la barrière conducteur-semiconducteur à une interface entre ladite région de type N et ladite couche de siliciure.

2. Dispositif semiconducteur selon la revendication 1, caractérisé en ce que t est au moins égal à 5 nm.

3. Dispositif semiconducteur selon la revendication 1, caractérisé en ce que la valeur absolue de

$$(\phi_{B0}-\phi_B)/(\phi_{B0}-\phi_{BN})$$

n'est pas inférieure à 0,15, où $\phi_{BN}$ est la hauteur de barrière métal-semiconducteur à une interface entre du matériau qui est le même que celui de la région de type N le long de la jonction et du matériau qui est le même que celui de la couche métallique.

4. Dispositif semiconducteur selon la revendication 2, caractérisé en ce que la valeur absolue de

$$(\phi_{B0}-\phi_B)/(\phi_{B0}-\phi_{BN})$$

n'est pas inférieure à 0,25.

5. Dispositif semiconducteur selon la revendication 2, caractérisé en ce que la couche métallique sert de barrière de diffusion au silicium et à l'aluminium à une température de 520°C au maximum.

6. Dispositif semiconducteur selon la revendication 3, caractérisé en ce que la couche de siliciure comporte une première couche contiguë à la région de type N et une seconde couche recouvrant la première couche et ayant une composition moyenne différente de celle de la première couche.

7. Dispositif semiconducteur selon la revendication 6, caractérisé en ce que la composition moyenne de la première couche est pratiquement $Ni_YPt_{1-Y}Si$, où Y peut varier entre 0 et 1, et en ce que la composition moyenne de la seconde couche est pratiquement $Ni_ZPt_{1-Z}Si$ où Z peut varier entre O et Y.

8. Dispositif semiconducteur selon l'une quelconque des revendications 1 à 7, caractérisé en ce que ladite couche de siliciure de métal est constituée au moyen d'au moins deux métaux sélectionnés et en ce que ladite couche de siliciure est le reste d'une couche originale de siliciure de métal d'épaisseur plus grande.

9. Dispositif semiconducteur selon l'une quelconque des revendications 1 à 8, comportant un redresseur ayant une hauteur de barrière effective conducteur-semiconducteur $\phi_{B1}$ et une hauteur de barrière intrinsèque $\phi_{B10}$, caractérisé en ce que le dispositif comporte en outre un autre redresseur muni d'une autre région semiconductrice de type N et d'une autre couche de siliciure de métal contiguë à ladite autre région de façon à définir une autre jonction redresseuse ayant une hauteur de barrière intrinsèque conducteur-semiconducteur $\phi_{B20}$ et une hauteur de barrière effective conducteur-semiconducteur $\phi_{B2}$ différente de $\phi_{B1}$.

10. Dispositif semiconducteur selon la revendication 9, caractérisé en ce que les régions de type N forment un ensemble continu et présentent pratiquement la même concentration de dopage nette de type N le long des jonctions, et en ce que les couches de siliciure ont pratiquement la même composition le long des jonctions et pratiquement la même composition moyenne, $\phi_{B10}$ étant égal à $\phi_{B20}$.

11. Dispositif semiconducteur selon la revendication 10, caractérisé en ce que les deux redresseurs présentent des couches métalliques comportant le même matériau ($\phi_{BN1}$ étant égal à $\phi_{BN2}$.

12. Dispositif semiconducteur selon l'une quelconque des revendications 9 et 11, caractérisé en ce que les couches de siliciure comportent le même siliciure de métal à des épaisseurs différentes.

Fig. 1

Fig. 2a

Fig. 2b

## Fig. 3

## Fig. 4

$$q\emptyset_{BO} = 0.81\,eV$$

$$q\emptyset_{BN} = 0.65\,eV\,(Ti-W)$$

2

Fig. 5

Fig. 6a

Fig. 6b

Fig. 6c

Fig. 6d

# Fig.7

# Fig.8

4

# Fig.9a

96 162 164 98 100 94 170 96

P+

N+ P− N+

N−

N+

P−

172 90 92 88

# Fig.9b

100 162 114 98 116 170 94

P+

N+ P− N+

N−

N+

P−

164

# Fig.9c

126 122 118 124 120A 120B 120C 94

P+

N+ P− N+

N−

N+

P−

162 164 98 170

# Fig.9d

102 106 82 168 104 108 80A 80B 80C
78A 78B 78C

P+

N+ P− N+

N−

N+

162 164 174 166 98 P− 76A 76B 76C 170